Europäisches Patentamt

European Patent Office

Office européen des brevets

(11) Publication number: **0 658 005 A1**

## EUROPEAN PATENT APPLICATION

(21) Application number: **94119414.4**

(22) Date of filing: **08.12.94**

(51) Int. Cl.⁶: **H03L 3/00**, H03K 3/03

(30) Priority: **08.12.93 JP 308242/93**

(43) Date of publication of application:
**14.06.95 Bulletin 95/24**

(84) Designated Contracting States:
**DE FR GB**

(71) Applicant: **NEC CORPORATION**
**7-1, Shiba 5-chome**
**Minato-ku**
**Tokyo (JP)**

(72) Inventor: **Narahara, Tetsuya, c/o NEC**
**Corporation**
**7-1, Shiba 5-chome, Minato-ku**
**Tokyo (JP)**

(74) Representative: **Baronetzky, Klaus, Dipl.-Ing.**
**et al**
**Patentanwälte**
**Dipl.-Ing. R. Splanemann, Dr. B. Reitzner,**
**Dipl.-Ing. K. Baronetzky**
**Tal 13**
**D-80331 München (DE)**

(54) **Oscillation circuit.**

㊗ The invention provides an oscillation circuitry having at least one three-state invertor circuit being shifted between in a high impedance output state and in performing an invertor function. The three state invertor circuit is controlled by a gain control circuit. The circuitry includes at least two of the three state invertor circuits, one of which being in the high impedance output state and other performing the invertor function.

**FIG.4**

EP 0 658 005 A1

The invention relates to an oscillation circuit, and more particularly to an oscillation circuit with a reduced current dissipation property.

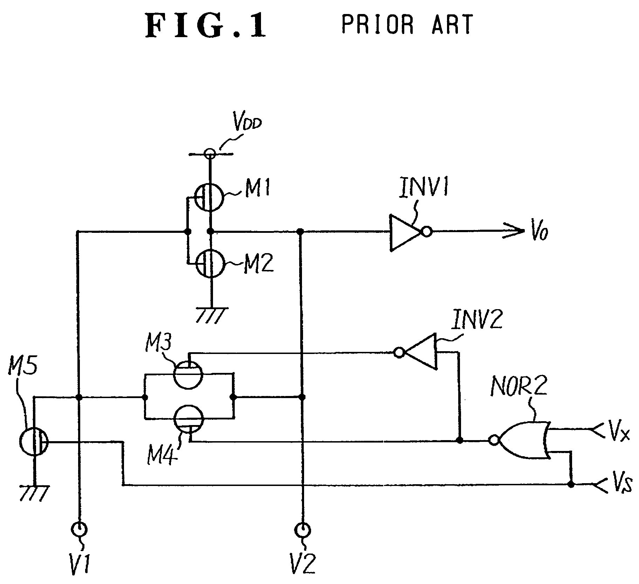

Various types of oscillation circuitries have been known in the art, one of which is illustrated in FIG. 1. A conventional oscillation control circuit includes an invertor circuit having an input connected to a terminal V1 and an output connected to a terminal V2 in which the invertor circuit comprises a pair of p-channel and n-channel MOS field effect transistors M1 and M2, both os which are connected in series between a high voltage line $V_{DD}$ and a ground line. The conventional oscillation control circuit also includes a transfer circuit connected between the terminals V1 and V2 and comprising a pair of p-channel and n-channel MOS field effect transistors M3 and M4. The conventional oscillation control circuit further includes an n-channel MOS field effect transistor M5 connected between the terminal V1 and the ground line, an invertor circuit INV1 having an input side connected to the terminal V2. The conventional oscillation circuit is moreover provided with an invertor circuit INV2 having an output connected to a gate of the p-channel MOS field effect transistor M3 and an input connected to a gate of the n-channel MOS transistor M4 as well as provided with a NOR gate circuit NOR2.

The oscillation circuit has three states in which a first state is in crystal oscillation, a second state is in an external clock signal oscillation state and an oscillation stop state. The three states are selectable by varying voltage levels of terminals $V_x$ and $V_s$.

In the crystal oscillation, a crystal oscillator is provided between the terminals V1 and V2 and further the terminals $V_x$ and $V_s$ come into low levels. As a result, the n-channel MOS field effect transistor M5 turns OFF and the p-channel MOS/field effect transistor M3 and the n-channel MOS filed effect transistor turn ON so that the transfer circuit turns ON performing as a feedback resistance. The invertor circuit comprising the p-channel MOS field effect transistor M1 and the n-channel MOS field effect transistor M2 performs as an alternating current amplifier for oscillation.

In the external clock signal oscillation, external clock signals are inputted into the terminal V1 as well as the terminals $V_x$ and $V_s$ come into the high and low levels respectively thereby the n-channel MOS field effect transistor M5 turns OFF as well as the transfer circuit comprising the n-channel and p-channel MOS field effect transistors M3 and M4 turns OFF. As a result, the external clock signals are transmitted through the invertor circuit comprising the p-channel and n-channel MOS field effect transistors M1 and M2 and further through the invertor circuits INV1 to an internal circuit that is not illustrated.

In the oscillation stop state, the terminal $V_s$ is in the high level so that the n-channel MOS field effect transistor M5 turns ON and further the transfer circuit comprising the p-channel and n-channel MOS field effect transistors M3 and M4 turns OFF thereby the terminals V1 and V2 come into the high level to stop the oscillation.

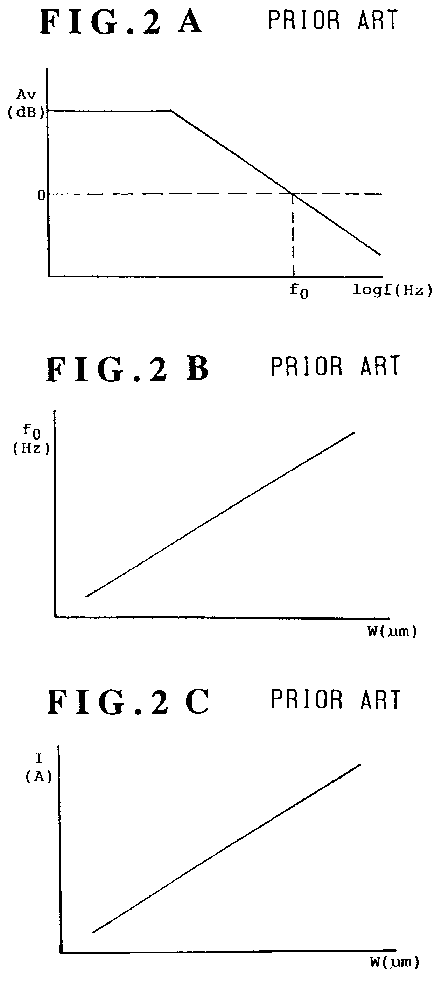

FIG. 2A illustrates a gain-frequency characteristic of the invertor circuit comprising the p-channel and n-channel MOS field effect transistors M1 and M2 to perform as the alternating current amplifier. The oscillation is available in the frequency range less than a $f_0$ at which the gain value is 0dB. The critical frequency $f_0$ is variable by varying a gate width of the MOS field effect transistor involved in the invertor circuit as illustrated in FIG. 2B. The critical frequency $f_0$ is varied so as to be proportional to the gate width of the MOS field effect transistors involved in the invertor circuit. Then, the gate width is required to be larger than a gate width value corresponding to a predetermined maximum oscillation frequency value. In the above viewpoint, a large gate width is preferable. On the other hand, a current dissipation I of the invertor circuit is also proportional to the gate width as illustrated in FIG. 2C. In this viewpoint, a small gate width is preferable.

Under the above described circumstances, the MOS field effect transistors involved in the invertor circuit are designed to have a width just larger than a gate width W1 corresponding to the maximum oscillation frequency $f_1$.

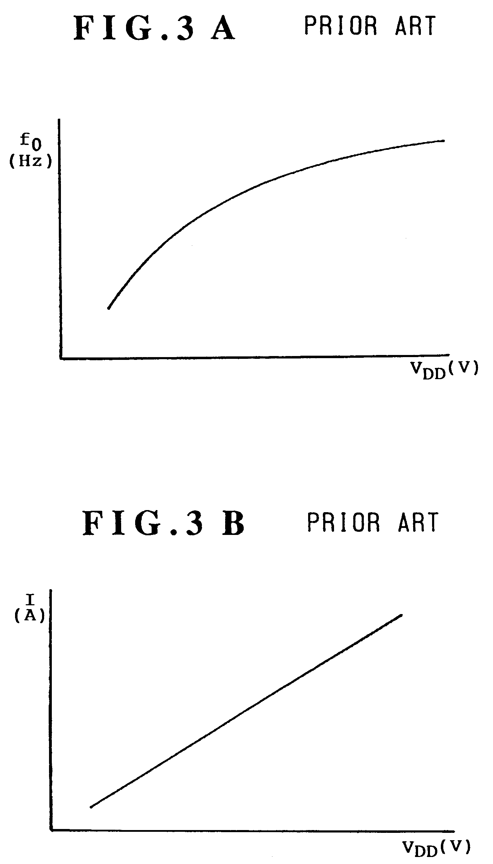

FIG. 3A illustrates a characteristic curve of the critical frequency $f_0$ versus the power voltage $V_{DD}$ of the invertor circuit. The critical frequency $f_0$ at which the gain value of the invertor circuit is dropped by a reduction of the power voltage $V_{DD}$. In the above viewpoint, it is required to determine the gate width of the MOS field effect transistor under the condition of an available lowest power voltage.

On the other hand, the power voltage $V_{DD}$ of the invertor circuit is proportional to the current dissipation thereof as illustrated in FIG. 3B. For that reason, the increase of the power voltage $V_{DD}$ results in an increase of the dissipation current. Under the condition of the oscillation frequency of 10MHz and the power voltage of 5V, the dissipation current is 1.2 mA. By contrast, when the oscillation circuit is designed to be available in the range of voltage from 3V to 5V and at the oscillation frequency of 10MHz and the power voltage of 5V, then the current dissipation is increased up to 1.5 mA.

In use of the external clock signal oscillation, a power voltage of a LSI creating the external clock signals to be inputted into the terminal V1 is low.

Namely, the external clock signal has a small amplitude that is subsequently inputted into the terminal V1. The invertor circuit serving as the alternating current amplifier comprising the p-channel and n-channel MOS field effect transistors M1 and M2 shows an insufficient gain property because the gain was previously set at a just larger value than 0dB, for example, 1dB = 1.12 times. As a result, the amplitude is insufficiently increased thereby the signal with the amplitude smaller than the power voltage is transmitted to the invertor circuit INV1 on the next stage. This may result in that the clock signal is not surely supplied to the internal circuit. For that reason, it is required to further provide an external level shfter.

Accordingly, it is a primary object of the present invention to provide a novel oscillation circuit being free from the problems as described above.

It is a further object of the present invention to provide a novel oscillation circuit having a reduced current dissipation property.

It is a furthermore object of the present invention to provide a novel oscillation circuit permitting a sufficient amplification to be available in wide ranges of voltages and frequency.

The above and other objects, features and advantages of the present invention will be apparent from the following descriptions.

The invention provides an oscillation circuitry having at least one three-state invertor circuit being shifted between in a high impedance output state and in performing an invertor function. The three state invertor circuit is controlled by a gain control circuit. The circuitry includes at least two of the three state invertor circuits, one of which being in the high impedance output state and other performing the invertor function.

Preferred embodiments of the present invention will hereinafter fully be described in detail with reference to the accompanying drawings.

FIG. 1 is a circuit diagram illustrative of the conventional oscillation circuit.

FIG. 2A is a diagram illustrative of a gain-frequency characteristic of the amplifier circuit involving the MOS field effect transistors.

FIG. 2B is a diagram illustrative of a frequency-gate width characteristic of the amplifier circuit involving the MOS field effect transistors.

FIG. 2C is a diagram illustrative of a current dissipation-gate width characteristic of the amplifier circuit involving the MOS field effect transistors.

FIG. 3A is a diagram illustrative of a frequency-power voltage characteristic curve of the amplifier circuit involving the MOS field effect transistors.

FIG. 3B is a diagram illustrative of a current dissipation-power voltage characteristic of the amplifier circuit involving the MOS field effect transistors.

FIG. 4 is a circuit diagram illustrative of a novel oscillation circuit of a first embodiment according to the present invention.

FIGS. 5A, 5B and 5C are diagrams illustrative of gain-frequency characteristics of amplifier circuits involved in a novel oscillation circuit of a first embodiment according to the present invention.

FIG. 6 is a circuit diagram illustrative of a novel oscillation circuit of a second embodiment according to the present invention.

FIG. 7 is a circuit diagram illustrative of a novel oscillation circuit of a third embodiment according to the present invention.

FIG. 8 is a circuit diagram illustrative of a novel oscillation circuit of a fourth embodiment according to the present invention.

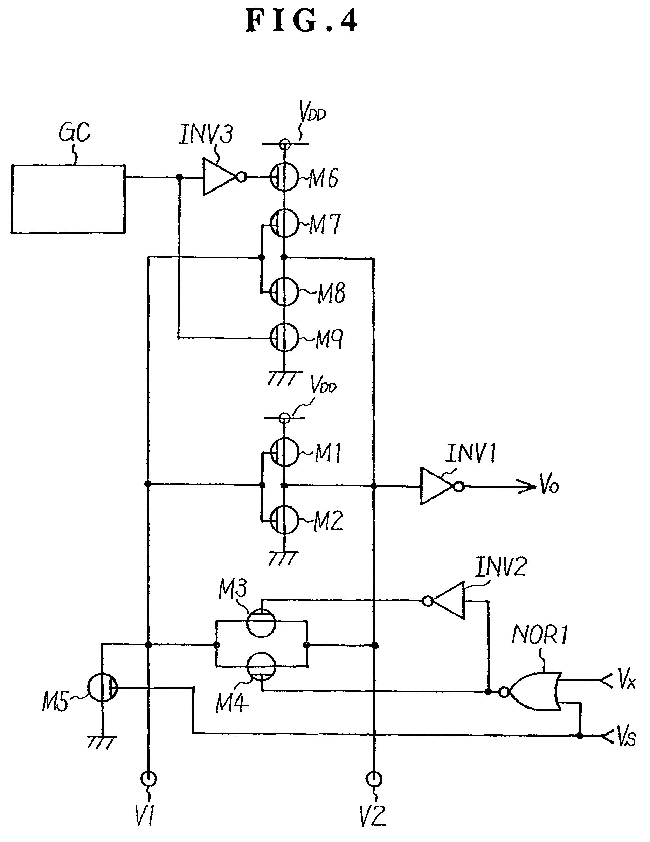

A first embodiment according to the present invention will be described in which a novel oscillation circuit with a reduced current dissipation property is provided that circuitry is illustrated in FIG. 4. The novel oscillation circuit has an invertor circuit comprising a pair of p-channel and n-channel MOS field effect transistors M1 and M2, both of which are connected in series between a ground line and a high voltage line applied with a power voltage $V_{DD}$. Gates of the p-channel and n-channel MOS field effect transistors M1 and M2 are connected connected to an input side of the invertor circuit. The invertor circuit has an input side of connected to a terminal V1 and an output side connected to a terminal V2. The oscillation circuit has a transfer circuit comprising a pair of p-channel and n-channel MOS field effect transistors M3 and M4, both of which are connected in parallel to each other between the terminals V1 and V2. The oscillation circuit has an n-channel MOS field effect transistor M5 connected between the ground line and the terminal V1. The oscillation circuit has an invertor circuit INV1 having an input side connected to the terminal V2 and an output side connected to an output terminal $V_0$ as the oscillation circuit. The oscillation circuit has an invertor circuit INV2 having an input side connected to a gate of the n-channel MOS field effect transistor M4 and an output side connected to a gate of the p-channel MOS field effect transistor M3. The oscillation circuit has a NOR gate circuit NOR1 having an output side connected to the gate of the MOS field effect transistor M4 and input sides connected to terminals $V_x$ and $V_s$ in which the terminal $V_s$ is connected to a gate of the n-channel MOS filed effect transistor M5.

The novel oscillation circuit has a difference from the conventional oscillation circuit in further providing a three state invertor circuit and a gain control circuit GC. The three state invertor circuit has input terminals, one of which is connected to the gain control circuit GC and another terminal being connected to the terminal V1. The three state invertor circuit has an output terminal connected to the terminal V2. The three state invertor circuit is connected between the power voltage line $V_{DD}$ and the ground line to receive the necessary bias for performing its operation.

The three state invertor circuit comprises p-channel MOS field effect transistors M6 and M7 and n-channel MOS field effect transistors M8 and M9 which are connected in series between the power voltage line and the ground line. The output terminal of the three state invertor circuit is provided between the p-channel and n-channel MOS field effect transistors M7 and M8. Gates of the p-channel and n-channel MOS field effect transistors M7 and M8 are connected to the terminal V1. A gate of the p-channel MOS field effect transistor M6 is connected to an output terminal of an invertor INV3 having an output terminal connected to the gain control circuit GC. A gate of the n-channel MOS field effect transistor M9 is connected directly to the gain control circuit without through the invertor INV3.

The oscillation circuit has three states in crystal oscillation, an external clock signal oscillation state and an oscillation stop state. The three states are selectable by varying voltage levels of the terminals $V_x$ and $V_s$.

In the crystal oscillation, a crystal oscillator is provided between the terminals V1 and V2 and further the terminals $V_x$ and $V_s$ come into low levels. As a result, the n-channel MOS field effect transistor M5 turns OFF and the p-channel MOS field effect transistor M3 and the n-channel MOS filed effect transistor M4 turn ON so that the transfer circuit turns ON performing as a feedback resistance. The invertor circuit comprising the p-channel MOS field effect transistor M1 and the n-channel MOS field effect transistor M2 performs as an alternating current amplifier for oscillation.

In the external clock signal oscillation, external clock signals are inputted into the terminal V1 as well as the terminals $V_x$ and $V_s$ come into the high and low levels respectively thereby the n-channel MOS field effect transistor M5 turns OFF as well as the transfer circuit comprising the n-channel and p-channel MOS field effect transistors M3 and M4 turns OFF. As a result, the external clock signals are transmitted through the invertor circuit comprising the p-channel and n-channel MOS field effect transistors M1 and M2 and further through the invertor circuits INV1 to an internal circuit that is not illustrated.

In the oscillation stop state, the terminal $V_s$ is in the high level so that the n-channel MOS field effect transistor M5 turns ON and further the transfer circuit comprising the p-channel and n-channel MOS field effect transistors M3 and M4 turns OFF thereby the terminals V1 and V2 come into the high level to stop the oscillation.

The gain control circuit is able to control the three state invertor circuit so that the three state invertor circuit is shifted between an alternating current amplifier state in which the three state invertor circuit may perform as a alternating current amplifier circuit and a high impedance output state in which the three state invertor circuit has an output of a high impedance.

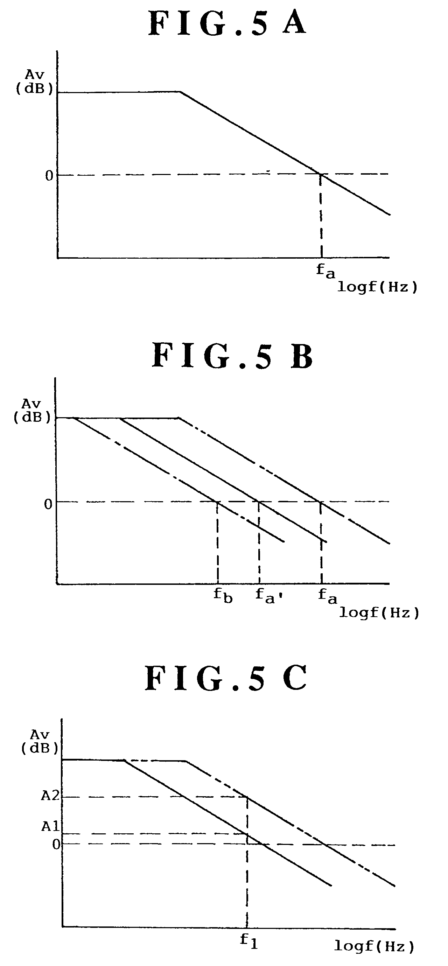

When the power voltage $V_{DD}$ is set at $V_{DD1}$, the invertor circuit performing as the alternating amplifier circuit comprising the p-channel and n-channel MOS field effect transistors M1 and M2 shows a gain-frequency characteristic as illustrated in FIG. 5A. A gate width W of each of the MOS field effect transistors is adjusted so that a critical frequency $f_a$ at which a gain is 0dB is just larger than a maximum oscillation frequency $f_1$.

When the power voltage $V_{DD}$ comes into $V_{DD2}$ smaller than $V_{DD1}$, the invertor circuit performing as the alternating amplifier circuit comprising the p-channel and n-channel MOS field effect transistors M1 and M2 shows a gain-frequency characteristic as illustrated in FIG. 5B. The critical frequency at which a gain is 0dB is shifted into $f_{a'}$ being smaller than $f_a$, for which reason at the maximum oscillation frequency $f_1$ the gain comes into minas thereby it is no longer possible to obtain any oscillation. In FIG. 5B, $f_b$ represents a frequency when the three state invertor circuit performs as an alternating current amplifier.

When at the power voltage of $V_{DD2}$ the three state invertor circuit is shifted by controlling the gain control circuit to perform as the alternating current amplifier circuit, then the critical frequency at which the gain of the oscillation circuit is 0dB comes into $f_b + f_a$. The gate width W of the MOS field effect transistors involved in the three state invertor circuit is so adjusted that the critical frequency at which the gain is 0dB is shifted from $f_b$ into $f_a - f_{a'}$. This permits an oscillation at the oscillation frequency $f_1$. When the power voltage $V_{DD}$ is $V_{DD2}$, the current dissipation of the novel oscillation circuit is the same as that of the conventional oscillation circuit. When the power voltage $V_{DD}$ is $V_{DD1}$, the current dissipation of the novel oscillation circuit is smaller than that of the conventional oscillation circuit. When the oscillation frequency is 10MHz and the power voltage is 3V, the current dissipation is 0.7mA of the same as that of the conventional oscillation circuit. When the oscillation frequency is 10MHz and the power voltage is 5V, the current dissipation is 1.2 mA which is reduced by 20% from 1.5 mA as the current dissipation of the conventional oscillation circuit.

The novel oscillation circuit has not only a reduced dependency of the current dissipation upon the power voltage but also the optimum current dissipation for the oscillation frequency. The current dissipation of the oscillation current mostly depends upon the gate width of the MOS field effect transistors involved in the amplifier, but almost not depend upon the oscillation frequency. For that reason, at the frequency $f_1$ lower than the maximum frequency, the current dissipation has almost no variation from the current dissipation at the maximum frequency. As illustrated in FIG. 5B, the gate width of the p-channel and n-channel MOS field effect transistors M1 and M2 constituting the invertor circuit is adjusted so that the critical frequency at which the gain is 0dB comes into a just larger value than the frequency $f_{1'}$. Further, the gate width of the p-channel MOS field effect transistor M6, the p-channel MOS field effect transistor M7, the n-channel MOS field effect transistor M8 and the n-channel MOS field effect transistor M9 constituting the three state invertor circuit is also adjusted so that the critical frequency $f_b$ at which the gain is 0dB comes into the value ($f_1 - f_{a'}$).

In the oscillation at the maximum oscillation frequency $f_1$, the gain control circuit so control that the three state invertor circuit performs the amplifier function together with the amplifier performance of the invertor comprising the p-channel and n-channel MOS field effect transistors M1 and M2.

In the oscillation at the smaller frequency $f_1o'$ than the maximum oscillation frequency $f_1$, the gain control circuit so control that the three state invertor circuit performs the high impedance output and the amplifier performance of the invertor comprising the p-channel and n-channel MOS field effect transistors M1 and M2.

As a result, at the lower oscillation frequency a reduction of the current dissipation of the oscillation circuit is obtained. When the conventional oscillation circuit designed for 10MHz is tested at 5MHz, then the current dissipation is 1.2mA. By contrast, when the novel oscillation circuit designed for 10MHz is tested at 5MHz, then the current dissipation is reduced to 0.6 mA.

When the crystal oscillation and the external clock signal oscillation are used by switching between those, it is preferable that the amplitude of the external clock signal is smaller than the power voltage of the oscillation circuit. In the crystal oscillation, it is available that at the maximum oscillation frequency $f_1$, the gain of the amplifier is a VALUE $A_1$ being just larger than 0dB as illustrated in FIG. 5C. The gate width of the invertor circuit comprising the p-channel and n-channel MOS field effect transistors M1 and M2 is so set that at the maximum frequency $f_1$ the gain of the amplifier comes into the value of $A_1$.

In the use of the external clock signals for the oscillation, the gain of the amplifier is so determined that an amplitude of input signals into the invertor circuit INV1 shares the full range of the power voltage. At the amplitude $V_c$ of the external clock signal and the power voltage $V_{DD}$, the gain control circuit at the frequency $f_1$ performs such a control that the three state invertor circuit may perform the amplifying function together with the amplifying function of the invertor circuit comprising the p-channel and n-channel MOS field effect transistors M1 and M2. The gate width of the MOS field effect transistors involved in the three state invertor circuit is so set that the total gain value $A_2$ of the three state invertor circuit and the invertor circuit comprising the p-channel and n-channel MOS field effect transistors M1 an M2 is given by the following equation.

$$A_2 = 20 \times \log(V_{DD}/V_c) \text{ (dB)}$$

As the result of the above, even if a small amplitude clock signal is supplied, a sufficient large amplification may be obtained thereby ensuring the correct and exact performances. This may make the novel oscillation circuit free from the requirement in providing the level shifter.

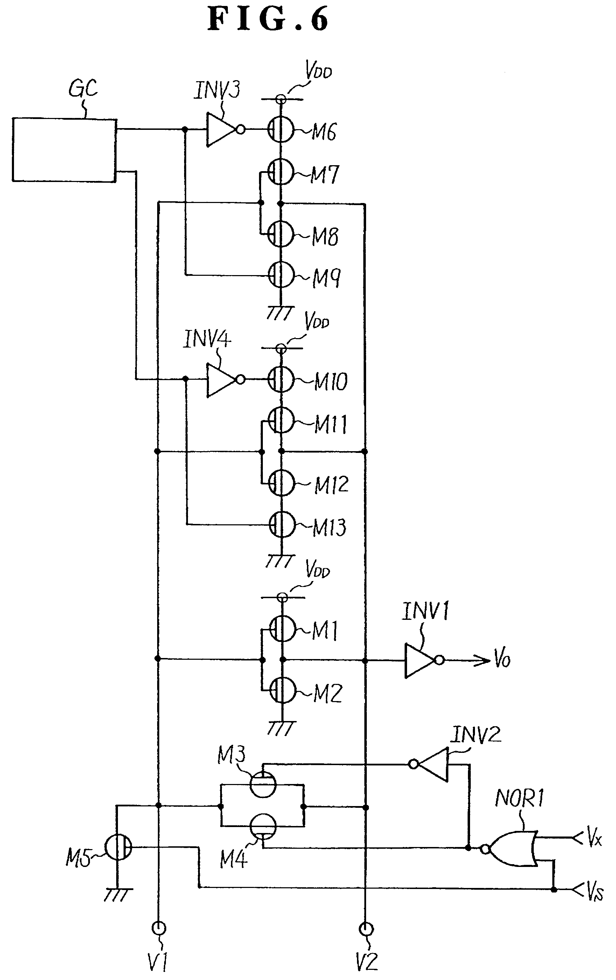

A second embodiment according to the present invention will be described in which a novel oscillation circuit with a reduced current dissipation property is provided that circuitry is illustrated in FIG. 6. The novel oscillation circuit has a structural difference from that of the first embodiment in further providing an additional three state invertor circuit. The novel oscillation circuit has an invertor circuit comprising a pair of p-channel and n-channel MOS field effect transistors M1 and M2, both of which are connected in series between a ground line and a high voltage line applied with a power voltage $V_{DD}$. Gates of the p-channel and n-channel MOS field effect transistors M1 and M2 are connected connected to an input side of the invertor circuit. The invertor circuit has an input side of connected to a terminal V1 and an output side connected to a terminal V2. The oscillation circuit has a transfer circuit comprising a pair of p-channel and n-channel MOS field effect transistors M3 and M4, both of which are connected in parallel to each other between the terminals V1 and V2. The oscillation circuit has an n-channel MOS field effect transistor M5 connected between the ground line and the terminal V1. The oscillation circuit has an invertor circuit INV1 having an input side connected to the terminal V2 and an output side connected to an output terminal $V_0$ as the oscillation circuit. The oscillation circuit has an invertor circuit INV2 having an input side connected to a gate of the n-channel MOS field effect transistor M4 and an output side connected to a gate of the p-channel MOS field effect transistor M3. The oscillation circuit has a NOR gate circuit NOR1 having an output side connected to the gate of the MOS field effect transistor M4 and input sides connected to terminals $V_x$ and $V_s$ in which the terminal $V_s$ is connected to a gate of the n-channel MOS filed effect transistor M5.

The novel oscillation circuit has two of three state invertor circuits and a gain control circuit GC. Each of the three state invertor circuits has input terminals, one of which is connected to the gain control circuit GC and another terminal being connected to the terminal V1. Each of the three state invertor circuits has an output terminal connected to the terminal V2. Each of the three state invertor circuit is connected between the power voltage line $V_{DD}$ and the ground line to receive the necessary bias for performing its operation.

The first three state invertor circuit comprises p-channel MOS field effect transistors M6 and M7 and n-channel MOS field effect transistors M8 and M9 which are connected in series between the power voltage line and the ground line. The output terminal of the three state invertor circuit is provided between the p-channel and n-channel MOS field effect transistors M7 and M8. Gates of the p-channel and n-channel MOS field effect transistors M7 and M8 are connected to the terminal V1. A gate of the p-channel MOS field effect transistor M6 is connected to an output terminal of an invertor INV3 having an output terminal connected to the gain control circuit GC. A gate of the n-channel MOS field effect transistor M9 is connected directly to the gain control circuit without through the invertor INV3.

The second three state invertor circuit comprises p-channel MOS field effect transistors M10 and M11 and n-channel MOS field effect transistors M12 and M13 which are connected in series between the power voltage line and the ground line. The output terminal of the three state invertor circuit is provided between the p-channel and n-channel MOS field effect transistors M11 and M12. Gates of the p-channel and n-channel MOS field effect transistors M11 and M12 are connected to the terminal V1. A gate of the p-channel MOS field effect transistor M10 is connected to an output terminal of an invertor INV4 having an output terminal connected to the gain control circuit GC. A gate of the n-channel MOS field effect transistor M13 is connected directly to the gain control circuit without through the invertor INV4.

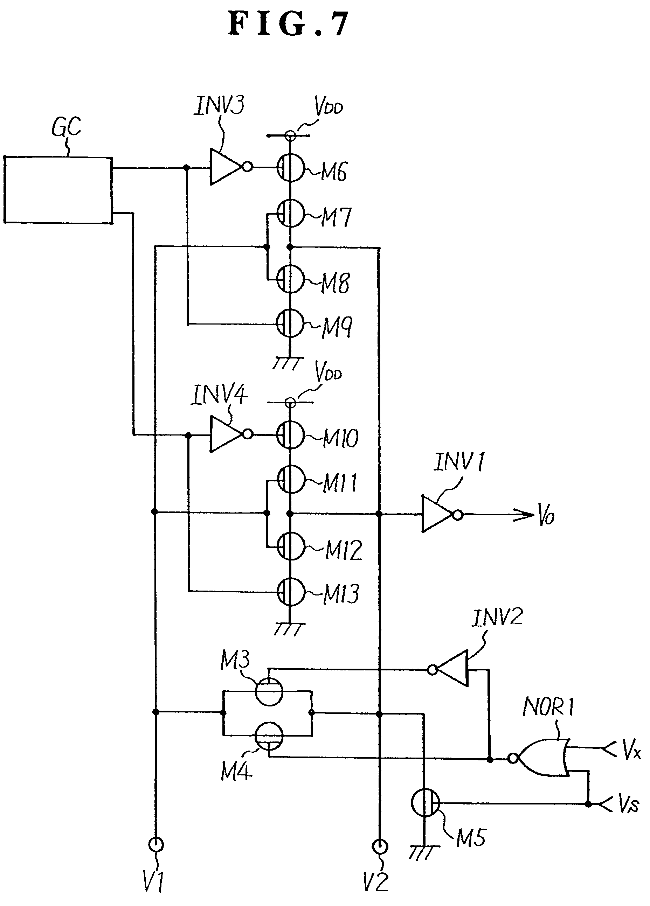

A third embodiment according to the present invention will be described in which a novel oscillation circuit with a reduced current dissipation property is provided that circuitry is illustrated in FIG. 7.

The novel oscillation circuit has a structural difference from that of the second embodiment in failure to providing an invertor circuit comprising a pair of p-channel and n-channel MOS field effect transistors.

The oscillation circuit has a transfer circuit comprising a pair of p-channel and n-channel MOS field effect transistors M3 and M4, both of which are connected in parallel to each other between the terminals V1 and V2. The oscillation circuit has an n-channel MOS field effect transistor M5 connected between the ground line and the terminal V2. The oscillation circuit has an invertor circuit INV1 having an input side connected to the terminal V2 and an output side connected to an output terminal $V_0$ as the oscillation circuit. The oscillation circuit has an invertor circuit INV2 having an input side connected to a gate of the n-channel MOS field effect transistor M4 and an output side connected to a gate of the p-channel MOS field effect transistor M3. The oscillation circuit has a NOR gate circuit NOR1 having an output side connected to the gate of the MOS field effect transistor M4 and input sides connected to terminals $V_x$ and $V_s$ in which the terminal $V_s$ is connected to a gate of the n-channel MOS filed effect transistor M5.

The novel oscillation circuit has two of three state invertor circuits and a gain control circuit GC. Each of the three state invertor circuits has input terminals, one of which is connected to the gain control circuit GC and another terminal being connected to the terminal V1. Each of the three state invertor circuits has an output terminal connected to the terminal V2. Each of the three state invertor circuit is connected between the power voltage line $V_{DD}$ and the ground line to receive the necessary bias for performing its operation.

The first three state invertor circuit comprises p-channel MOS field effect transistors M6 and M7 and n-channel MOS field effect transistors M8 and M9 which are connected in series between the power voltage line and the ground line. The output terminal of the three state invertor circuit is provided between the p-channel and n-channel MOS field effect transistors M7 and M8. Gates of the p-channel and n-channel MOS field effect transistors M7 and M8 are connected to the terminal V1. A gate of the p-channel MOS field effect transistor M6 is connected to an output terminal of an invertor INV3 having an output terminal connected to the gain control circuit GC. A gate of the n-channel MOS field effect transistor M9 is connected directly to the gain control circuit without through the invertor INV3.

The second three state invertor circuit comprises p-channel MOS field effect transistors M10 and M11 and n-channel MOS field effect transistors M12 and M13 which are connected in series between the power voltage line and the ground line. The output terminal of the three state invertor circuit is provided between the p-channel and n-channel MOS field effect transistors M11 and M12. Gates of the p-channel and n-channel MOS field effect transistors M11 and M12 are connected to the terminal V1. A gate of the p-channel MOS field effect transistor M10 is connected to an output terminal of an invertor INV4 having an output terminal connected to the gain control circuit GC. A gate of the n-channel MOS field effect transistor M13 is connected directly to the gain control circuit without through the invertor INV4.

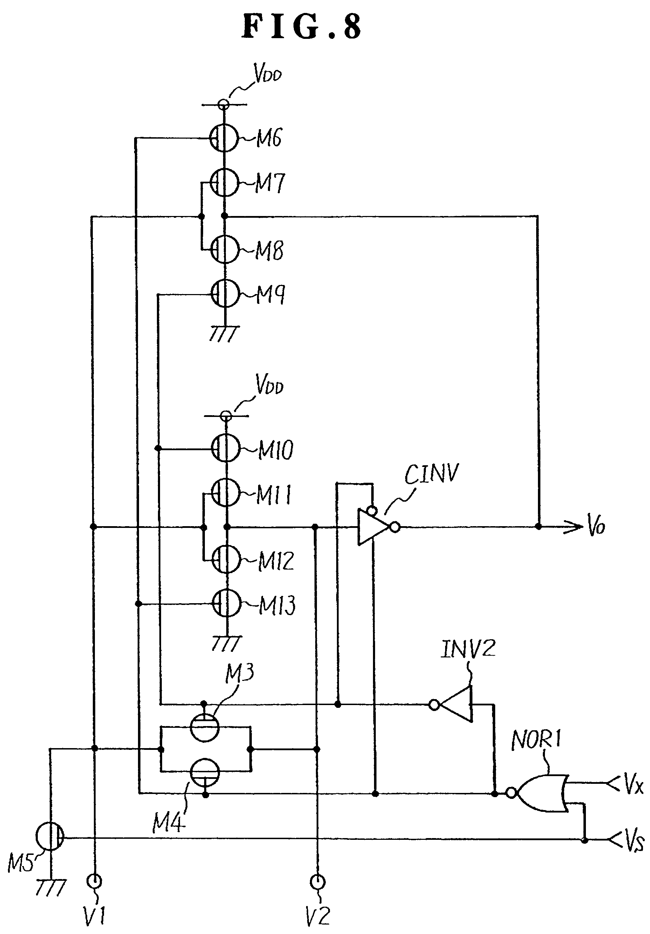

A fourth embodiment according to the present invention will be described in which a novel oscillation circuit with a reduced current dissipation property is provided that circuitry is illustrated in FIG. 8.

The oscillation circuit has a transfer circuit comprising a pair of p-channel and n-channel MOS field effect transistors M3 and M4, both of which are connected in parallel to each other between the terminals V1 and V2. The oscillation circuit has an n-channel MOS field effect transistor M5 connected between the ground line and the terminal V1. The oscillation circuit has an invertor circuit INV2 having an input side connected to a gate of the n-channel MOS field effect transistor M4 and an output side connected to a gate of the p-channel MOS field effect transistor M3. The oscillation circuit has a NOR gate circuit NOR1 having an output side connected to the gate of the MOS field effect transistor M4 and input sides connected to terminals $V_x$ and $V_s$ in which the terminal $V_s$ is connected to a gate of the n-channel MOS filed effect transistor M5.

The novel oscillation circuit has two of three state invertor circuits. Each of the three state invertor circuits has three input terminals in which a first one is connected to the output side of the NOR gate circuit NOR1, a second one is connected to an output side of the invertor circuit INV2 and a third one is connected to the terminal V1. The first three state invertor circuits has an output terminal connected to an output terminal V0. The second three state invertor circuits has an output terminal connected to an output terminal V2. Each of the first and second three state invertor circuits is connected between the power voltage line $V_{DD}$ and the ground line to receive the necessary bias for performing its operation.

The first three state invertor circuit comprises p-channel MOS field effect transistors M6 and M7 and n-channel MOS field effect transistors M8 and M9 which are connected in series between the power voltage line and the ground line. The output terminal of the three state invertor circuit is provided between the p-channel and n-channel MOS field effect transistors M7 and M8. Gates of the p-channel and n-channel MOS field effect transistors M7 and M8 are connected to the terminal V1. A gate of the p-channel MOS field effect transistor M6 is connected to the output side of the NOR gate NOR1. A gate of the n-channel MOS field effect transistor M9 is connected to the output side of the invertor INV2.

The second three state invertor circuit comprises p-channel MOS field effect transistors M10 and M11 and n-channel MOS field effect transistors M12 and M13 which are connected in series between the power voltage line and the ground line. The output terminal of the three state invertor circuit is provided between the p-channel and n-channel MOS field effect transistors M11 and M12. Gates of the p-channel and n-channel MOS field effect transistors M11 and M12 are connected to the terminal V1. A gate of the p-channel MOS field effect transistor M10 is connected to the output terminal of the invertor INV2. A gate of the n-channel MOS field effect transistor M13 is connected to the output terminal of the NOR gate circuit NOR1.

The novel oscillation circuit further includes a three state invertor circuit CINV having an input terminal connected to the terminal V2 and an output terminal connected to the output terminal $V_0$. The three state invertor circuit CINV is biased between the lines connected to the gates of the p-channel and n-channel MOS field effect transistors M3 and M4 forming the transfer circuit.

The oscillation circuit has three states in crystal oscillation, an external clock signal oscillation state and an oscillation stop state. The three states are selectable by varying voltage levels of the terminals $V_x$ and $V_s$.

In the crystal oscillation, a crystal oscillator is provided between the terminals V1 and V2 and further the terminals $V_x$ and $V_s$ come into low levels. As a result, the n-channel MOS field effect transistor M5 turns OFF and the p-channel MOS field effect transistor M3 and the n-channel MOS filed effect transistor M4 turn ON so that the transfer circuit turns ON performing as a feedback resistance. The first three state invertor circuit comes into the high impedance output state. The second three state invertor circuit performs the amplification function. The three state invertor circuit CINV performs as the invertor circuit.

In the external clock signal oscillation, external clock signals are inputted into the terminal V1 as well as the terminals $V_x$ and $V_s$ come into the high and low levels respectively thereby the n-channel MOS field effect transistor M5 turns OFF as well as the transfer circuit comprising the n-channel and p-channel MOS field effect transistors M3 and M4 turns OFF. The first three state invertor circuit performs the amplification function. The second three state invertor circuit comes into the high impedance output state. The three state invertor circuit CINV comes into the high impedance output state.

In the oscillation stop state, the terminal $V_s$ is in the high level so that the n-channel MOS field effect transistor M5 turns ON and further the transfer circuit comprising the p-channel and n-channel MOS field effect transistors M3 and M4 turns OFF thereby the terminals V1 and V2 come into the high level to stop the oscillation.

The first three state invertor circuit exclusively performs for the external clock signal amplification. The gate width of the MOS field effect transistors involved in the first three state invertor circuit is so adjusted that the gain permits amplifications of the external clock signal amplitude is increased up to the power voltage. The second three state invertor circuit exclusively performs for the crystal oscillation. The gate width of the MOS field effect transistors involved in the second three state invertor circuit is so adjusted that at the maximum oscillation frequency the gain is just larger than 0dB.

The output side of the first three state invertor circuit is not connected to the terminal V2. This may permit an improvement in performance of the oscillation circuit in the crystal oscillation state. In the external clock signal state, the voltage of the terminal V2 is made free.

As modifications of the fourth embodiment, it is available that a plurality of three state invertor circuits are connected in parallel to each other and a gain control circuit is provided to control the three state invertor circuits for switching the gain values similarly to the first embodiment.

Whereas modifications of the present invention will no doubt be apparent to a person having ordinary skill in the art, to which the invention pertains, it is to be understood that embodiments as described by way of illustrations are by no means intended to be considered in a limiting sense. Accordingly, it is to be intended to cover by claims all modifications of the present invention which fall within the sprit and scope of he invention.

## Claims

1. An oscillation circuitry having at least one three-state invertor circuit being shifted between in a high impedance output state and in performing an invertor function.

2. The circuitry as claimed in claim 1, characterized in that said three state invertor circuit is controlled by a gain control circuit.

3. The circuitry as claimed in claim 2, characterized in that said circuitry includes at least two of said three state invertor circuits, one of which being in the high impedance output state and other performing the invertor function.

4. The circuitry as claimed in claim 3, characterized in that said at least two of said three state invertor circuits are connected in parallel to each other.

# FIG.1 PRIOR ART

# FIG.2 A  PRIOR ART

# FIG.2 B  PRIOR ART

# FIG.2 C  PRIOR ART

# FIG.3 A    PRIOR ART

# FIG.3 B    PRIOR ART

EP 0 658 005 A1

# F I G . 4

12

# F I G . 5 A

# F I G . 5 B

# F I G . 5 C

# FIG.6

# FIG.7

# FIG.8

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X<br>Y | US-A-4 896 122 (O. TAHERNIA ET AL.)<br>* column 2, line 1 - column 5, line 66; figures 2,3 *<br>--- | 1,2<br>3,4 | H03L3/00<br>H03K3/03 |
| X<br>Y | EP-A-0 234 306 (NEC CORPORATION)<br>* column 2, line 11 - column 12, line 18; figures 4,7,8 *<br>--- | 1-3<br>4 | |
| Y | US-A-5 041 802 (T.S. WEI ET AL.)<br>* abstract; figures 1-3 *<br>--- | 3,4 | |
| Y | GB-A-2 040 633 (TOKYO SHIBAURA DENKI)<br>* abstract; figure 1 *<br>--- | 3,4 | |
| Y | DE-A-26 16 678 (HITACHI LTD)<br>* page 3, line 1 - page 4, line 1; figure 1 *<br>--- | 3,4 | |
| Y | WO-A-93 05466 (SEIKO EPSON CORPORATION)<br>* page 2, line 7 - page 3, line 19; figure 1 *<br>--- | 4 | |
| Y | EP-A-0 488 394 (TOSHIBA MICRO-ELECTRONICS CORPORATION)<br>* page 4, line 1 - page 5, line 46; figures 4,5 *<br>----- | 4 | TECHNICAL FIELDS SEARCHED (Int.Cl.6)<br><br>H03L<br>H03K |

The present search report has been drawn up for all claims

| Place of search | Date of completion of the search | Examiner |
|---|---|---|
| THE HAGUE | 27 February 1995 | Dhondt, I |

EPO FORM 1503 03.82 (P04C01)